# EUROPEAN PATENT APPLICATION

(11) **EP 4 361 323 A1**
(43) Date of publication of application: **01.05.2024**
(21) Application number: 22827001.3
(22) Date of filing: 16.02.2022
(51) Int. Cl.: C30B 23/02, C30B 25/14, C30B 31/16

(54) **DILUTION DEVICE FOR EPITAXIAL DOPING GAS**

(30) Priority: 23.06.2021 CN 202121408826 U
(71) Applicant: Wafer Works Epitaxial Corp., Qingpu Shanghai 201707 (CN)
(72) Inventor: GU, Guangan, Shanghai 201707 (CN); CHEN, Jiangang, Shanghai 201707 (CN); WANG, Junjie, Shanghai 201707 (CN)
(74) Representative: Cabinet Chaillot
(86) International application number: PCT/CN2022/076525
(87) International publication number: WO 2022/267492

(57) **Abstract**

The invention relates to a diluting device for epitaxial doping gas, comprising a first pipeline through which doping gas passes, a concentration detection mechanism and a first flow control mechanism being provided on the first pipeline; and a controller, signally connected to the concentration detection mechanism and the first flow control mechanism. Diluted doping gas provided by the diluting device disclosed in the present invention has a stable concentration, ensuring the obtained epitaxial layer has a stable resistivity.

## Description

### BACKGROUND OF THE INVENTION

### 1. Field of the Invention

The invention relates to an epitaxial growth device, and more particularly, to a diluting device for epitaxial doping gas.

### 2. Description of the Related Art

Doping is one of the most important steps in the epitaxial growth process. During the process of epitaxial growth, it is necessary to control and ensure the conductivity type and resistivity of an epitaxial layer by controlling the doping process. Main dopant sources commonly used in the manufacture of silicon epitaxy are phosphine, arsine and diborane, etc. Those dopant sources in the form of gas phase, together with a silicon source and a main gas flow constituting epitaxy, enter an epitaxy reaction chamber. In addition, all of those sources are doped into the epitaxial layer during the epitaxial growth. An amount of the dopant in the silicon epitaxial layer, that is, the resistivity of the epitaxial layer, can be controlled by controlling the doping concentration and flow rate. Therefore, the stability of the resistivity of the epitaxial layer depends on the long-term stability of the concentration and flow rate of dope gas.

In the prior art, generally, doping gas in a gas cylinder and diluting gas in the gas cylinder are mixed in a certain proportion and then it is output to a reaction chamber for epitaxial growth. The concentration of the doping gas in the cylinder will inevitably fluctuate when in use, and the concentration inevitably varies from one cylinder to anther cylinder. Therefore, stability of doping concentration cannot be guaranteed when a single cylinder is being used or the cylinder is replaced, which may directly affect the quality of a product.

### SUMMARY OF THE INVENTION

A main object of the invention is to provide a diluting device for epitaxial doping gas, the device is capable of providing a long-term stable doping concentration.

In order to achieve the above-mentioned object, the invention provides a diluting device for epitaxial doping gas, comprising
a first pipeline, through which doping gas passes, a concentration detection mechanism and a first flow control mechanism being provided on the first pipeline; and
a controller, signally connected to the concentration detection mechanism and the first flow control mechanism.

In some embodiments, the diluting device for epitaxial doping gas further comprises a second pipeline through which the doping gas passes.

In some embodiments, a second flow control mechanism is provided on the second pipeline, the controller is signally connected to the second flow control mechanism.

In some embodiments, a first control valve and a second control valve are arranged at a front position and a rear position of the second flow control mechanism on the second pipeline, respectively, the first and second control valves are signally connected to the controller.

In some embodiments, the diluting device for epitaxial doping gas further comprises a gas mixing mechanism and a third pipeline, wherein both an outlet of the first pipeline and an outlet of the second pipeline are connected to an inlet of the gas mixing mechanism, and an outlet of the mixing mechanism is connected to an inlet of the third pipeline.

In some embodiments, the gas mixing mechanism adopts a pressure accumulator.

In some embodiments, one or more of a pressure regulator, a pressure sensor, an emptying pipeline, and a valve are arranged on the third pipeline.

In some embodiments, a third control valve and a fourth control valve are arranged at a front position and a rear position of the first flow control mechanism on the first pipeline, respectively, the third and fourth control valves are signally connected to the controller.

In some embodiments, the diluting device for epitaxial doping gas further comprises an instrument gas pipeline, wherein an instrument gas control valve is disposed on the instrument gas pipeline, and the controller is signally connected to the instrument gas control valve.

In some embodiments, the diluting device for epitaxial doping gas further comprises a temperature regulator, and the temperature regulator is configured to regulate the ambient temperature of the concentration detection mechanism.

Doping gas, diluted by the diluting device disclosed in the present invention, has a long-term stable concentration, ensuring an epitaxial layer has a stable resistivity.

### BRIEF DESCRIPTION OF THE DRAWINGS

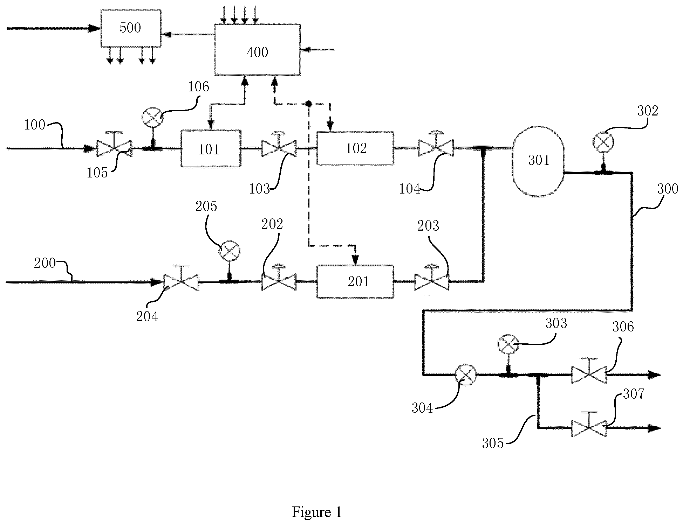

Figure 1 is a schematic diagram of a structure of a diluting device according to the present invention.

In the accompanying drawings: 100 a first pipeline, 101 a concentration detection mechanism, 102 a first flow control mechanism, 103 a third control valve, 104 a fourth control valve, 200 a second pipeline, 201 a second flow control mechanism, 202 a first control valve, 203 a second control valve, 300 a third pipeline, 301 a gas mixing mechanism, 304 a pressure regulator, 305 emptying pipeline, 400 a controller, 500 an instrument gas control valve, 106, 205, 302, 303, pressure sensors, 105, 204, 306, 307, manually operated valves.

### DETAILED DESCRIPTION

The present invention will now be described more fully hereinafter with reference to the accompanying drawings, in which exemplary embodiments of the invention are shown.

As shown in Figure 1, a diluting device for epitaxial doping gas in this embodiment mainly comprises:
a first pipeline 100, through which doping gas passes, a concentration detection mechanism 101 and a first flow control mechanism 102 being provided on the first pipeline 100; and a controller 400, signally connected to the concentration detection mechanism 101 and the first flow control mechanism 102. According to a concentration of a dopant in the doping gas detected by the concentration detection mechanism 101, the controller 400 sends a control signal to the first flow control mechanism 102 to control the flow of the doping gas sent from an outlet of the first pipeline 100 at dilution ratio predetermined value preset in the controller 400, so as to stabilize the doping concentration of the diluted doping gas. The concentration detection mechanism 101 can be a concentration sensor, the first flow control mechanism 102 can be a flow control valve, and the controller 400 can be a programmable controller.

In this embodiment, the device further comprises a second pipeline 200 through which the doping gas passes. A second flow control mechanism 201 is provided on the second pipeline 200, the controller 400 is signally connected to the second flow control mechanism 201. The second pipeline 200 delivers diluted gas for diluting the doping gas. According to the preset dilution ratio set value in the controller, on the one hand, the first flow control mechanism 102 can control a flow rate of the doping gas in the first pipeline 100, on the other hand, a control signal can also be sent to the second flow control mechanism 201 to control the flow rate of the diluted gas sent from the outlet of the second pipeline 200. The flow rates of the doping gas and the diluting gas are regulated simultaneously to improve the regulation efficiency, so that the dopant concentration is more stable. The second flow control mechanism 201 can also be a flow control valve.

In some embodiments, the diluting device for epitaxial doping gas further comprises a gas mixing mechanism 301 and a third pipeline 300, wherein both an outlet of the first pipeline 100 and an outlet of the second pipeline 200 are connected to an inlet of the gas mixing mechanism, and an outlet of the mixing mechanism is connected to an inlet of the third pipeline 300. The gas mixing mechanism 301 is a pressure accumulator. On the one hand, the pressure accumulator can be used to prevent large fluctuations in pressure, and on the other hand, the pressure accumulated in the pressure accumulator can help fully mix the doping gas and the diluting gas, enhancing the mixing effect. One or more of a pressure regulator 304, a pressure sensor 303, an emptying pipeline 305, and a manually operated valve 306 are arranged on the third pipeline 300. The emptying pipeline 305 is provided to discharge the remaining gas in a discharge pipeline after the epitaxial growth is completed. On the other hand, the first pipeline 100, the third pipeline 300 and the emptying pipeline 305 can form a calibration channel for the concentration detection mechanism 101. During the calibration, calibration gas is introduced from the inlet of a first channel, and the calibration gas is discharged from the emptying pipeline 305 after passing through the concentration detection mechanism 101.

In this embodiment, a third control valve 103 and a fourth control valve 104 are arranged at a front position and a rear position of the first flow control mechanism 102 on the first pipeline 100, respectively, the third and fourth control valves 103, 104 are signally connected to the controller 400. A first control valve 202 and a second control valve 203 are arranged at a front position and a rear position of the second flow control mechanism 201 on the second pipeline 200, respectively, the first and second control valves 202, 203 are signally connected to the controller 400. When the first flow control mechanism 102 and the second flow control mechanism 201 stop working, the third control value 103 and the fourth control vale 104 on both ends of the first flow control mechanism 102, and the first control valve 202 and the second control valve 203 on both ends of the second flow control mechanism 201 can be closed, so that the concentration of diluted doping gas in the subsequent pressure accumulator will not be affected by the leakage of the first and second flow control mechanisms 102, 201.

In this embodiment, the diluting device for epitaxial doping gas further comprises an instrument gas pipeline, wherein an instrument gas control valve 500 is disposed on the instrument gas pipeline, and the controller 400 is signally connected to the instrument gas control valve 500. The controller 400 controls the instrument gas control valve 500 to improve the automation level of a device.

In this embodiment, the diluting device for epitaxial doping gas further comprises a temperature regulator, and the temperature regulator is configured to regulate the ambient temperature of the concentration detection mechanism 101. The addition of the external temperature regulator reduces the effect of external environment factors on detection results.

In addition, a manually operated valve 105 and a pressure sensor 106 can be provided on the first pipeline 100, a manually operated valve 204 and a pressure sensor 205 can be provided on the second pipeline, and a manually operated valve 307 is provided on the emptying pipeline 305, so that it is possible to manually adjust the diluting device.

When the doping gas is diluted, the doping gas, for example, phosphine, is introduced at the inlet of the first pipeline 100, the diluting gas, for example, hydrogen, is introduced into the second pipeline 200. The concentration detection mechanism 101 sends the detected concentration value of phosphine to the controller 400. The controller 400 adjusts the first flow control mechanism 102 and the second flow control mechanism 201 according to the preset dilution ratio to realize the preset dilution ratio, and the phosphine and hydrogen enter the gas mixing mechanism 301 for mixing, and pressure is stabilized. Pressure of the diluted doping gas is regulated by the pressure regulator 304 on the third pipeline 300 and the regulated doping gas is sent to the reaction chamber for doping.

Comparing products produced by a conventional method in which a cylinder gas is supplied as a gas source, with products produced by the same concentration of gas source via the diluting device of the invention, and results are as follows:

| | First production detection | Second production detection | Third production detection | Fourth production detection | Fifth production detection |
|---|---|---|---|---|---|
| Cylinder gas source | 1.342 | 1.337 | 1.328 | 1.344 | 1.336 |
| Diluting device gas source | 1.336 | 1.337 | 1.334 | 1.336 | 1.333 |

The experimental results in the above-mentioned table show that resistivity fluctuation of an epitaxial wafer produced by the gas supply of the diluting device of the present invention is much smaller than that of the original gas supply system. The diluting device of the present invention can obtain doping gas whose dopant concentration remains stable for a long period of time. The diluting device of the present invention can ensure a long-term stable supply of concentration. In this way, more stable epitaxial resistivity. As a result, it is suitable for use in mass production, and it is applicable for use in production.

The above descriptions are only the preferred embodiments of the invention, not thus limiting the embodiments and scope of the invention. Those skilled in the art should be able to realize that the schemes obtained from the content of specification and drawings of the invention are within the scope of the invention.

## Claims

1. A diluting device for epitaxial doping gas, comprising
a first pipeline, through which doping gas passes, a concentration detection mechanism and a first flow control mechanism being provided on the first pipeline; and
a controller, signally connected to the concentration detection mechanism and the first flow control mechanism.

2. The diluting device for epitaxial doping gas according to claim 1, further comprising a second pipeline through which the doping gas passes.

3. The diluting device for epitaxial doping gas according to claim 2, wherein a second flow control mechanism is provided on the second pipeline, the controller is signally connected to the second flow control mechanism.

4. The diluting device for epitaxial doping gas according to claim 3, wherein a first control valve and a second control valve are arranged at a front position and a rear position of the second flow control mechanism on the second pipeline, respectively, the first and second control valves are signally connected to the controller.

5. The diluting device for epitaxial doping gas according to claim 2, further comprising a gas mixing mechanism and a third pipeline, wherein both an outlet of the first pipeline and an outlet of the second pipeline are connected to an inlet of the gas mixing mechanism, and an outlet of the mixing mechanism is connected to an inlet of the third pipeline.

6. The diluting device for epitaxial doping gas according to claim 5, wherein the gas mixing mechanism adopts a pressure accumulator.

7. The diluting device for epitaxial doping gas according to claim 5, wherein one or more of a pressure regulator, a pressure sensor, an emptying pipeline, and a valve are arranged on the third pipeline.

8. The diluting device for epitaxial doping gas according to claim 1, wherein a third control valve and a fourth control valve are arranged at a front position and a rear position of the first flow control mechanism on the first pipeline, respectively, the third and fourth control valves are signally connected to the controller.

9. The diluting device for epitaxial doping gas according to claim 1, further comprising an instrument gas pipeline, wherein an instrument gas control valve is disposed on the instrument gas pipeline, and the controller is signally connected to the instrument gas control valve.

10. The diluting device for epitaxial doping gas according to claim 1, further comprising a temperature regulator, and the temperature regulator is configured to regulate the ambient temperature of the concentration detection mechanism.
